# EUROPÄISCHE PATENTSCHRIFT

(11) **EP 0 805 494 B1**
(45) Veröffentlichungstag und Bekanntmachung des Hinweises auf die Patenterteilung: **17.05.2006**
(21) Anmeldenummer: 97101098.8
(22) Anmeldetag: 24.01.1997
(51) Int. Cl.: H01L 23/538, H01L 23/373, H01L 21/607

(54) **Halbleiterleistungsmodul hoher Packungsdichte in Mehrschichtbauweise**
Semiconductor multilayer power module having high package density
Module multi-couche semi-conducteur de puissance à haute densité d'empaquetage

(30) Priorität: 29.04.1996 DE 19617055
(43) Veröffentlichungstag der Anmeldung: 05.11.1997
(73) Patentinhaber: SEMIKRON Elektronik GmbH & Co. KG, 90431 Nürnberg (DE)
(72) Erfinder: Heilbronner, Heinrich, Dr., 90547 Stein (DE)

(56) Entgegenhaltungen:
- DE-A- 4 132 947
- DE-A- 4 407 810
- US-A- 4 677 528
- US-A- 5 067 004
- YAMAGUCHI S ET AL: "PACKAGING TECHNOLOGY FOR HIGH-SPEED MULTICHIP MODULE USING COPPER-POLYIMIDE THIN FILM MULTILAYER SUBSTRATE" PROCEEDINGS OF THE INTERNATIONAL ELECTRONICS MANUFACTURING TECHNOLO SYMPOSIUM, SANTA CLARA, OCT. 4 - 6, 1993, Nr. SYMP. 15, 4. Oktober 1993, Seiten 406-410, XP000457663 INSTITUTE OF ELECTRICAL AND ELECTRONICS ENGINEERS

## Beschreibung

Die vorliegende Erfindung beschreibt ein Halbleiterleistungsmodul der Leistungselektronik in Mehrschicht- bzw. Sandwichaufbauweise nach den Merkmalen des Oberbegriffes des Anspruches 1, sowie ein Verfahren zu dessen Herstellung.

Bei der weiteren Erhöhung der Zuverlässigkeit, der Lebensdauer und Leistungsdichte von Halbleiterleistungsmodulen sind veränderte neue Methoden des Zusammenfügens der einzelnen Aufbauteile zu einer Einheit und neue Stoffkombinationen erforderliche Voraussetzung.

Gefordert wird ein isolierter Aufbau der Leistungshalbleiterbauelemente bei sehr guter Wärmeleitfähigkeit zum Abtransport der entstehenden Verlustwärme an den pn- Übergängen und ihre Integration zu verschiedenen Schaltungsarten, die zu äußeren Anschlüssen führen.

Beim isolierten Aufbau von Halbleiterleistungsmodulen mittels mit Kupfer beschichteten isolierenden, wärmeleitenden Substraten werden die aktiven Bauelemente gelötet, diese stoffschlüssige Verbindung gewährleistet einen guten Wärmeabtransport und eine gut justierte Lage der Einzelelemente in der Anordnung.

Die Herstellung der schaltungsgerechten Verbindungen der Halbleiterbauelemente und deren Freilaufdioden auf deren Oberseite ist in Kommutierungskreisen bei Schaltungsanordnungen der Umform- und Ansteuertechnik bisher üblicherweise der Bondtechnik überlassen, da die relativ feine Strukturierung der Chipkontaktflächen bisher keine alternative Kontaktierung zuließen. Es werden beispielhaft bis zu 330 µm dicke Aluminiumdrähte mittels Ultraschall als Verbindungen zwischen den Chipkontaktstellen und den sekundären Verbindungselementen auf der DCB-Keramik stoffschlüssig in mehrfach paralleler Weise mittels Ultraschall gebondet.

Der Draht erhält beim Bonden durch den Ultraschall und den Druck des Bondmeißels bedingt eine Gefügeveränderung, die für die Stabilität im Langzeitbetrieb von Nachteil ist. Die wünschenswerte optimale Langzeitstabilität kann mit dieser Technik noch nicht erreicht werden. Frühzeitig zeigen die Aluminiumdrähte an den Bondstellen Risse im Gerüge, was bis zum Öffnen der Verbindung Chipkontaktfläche/Aluminiumdraht führt.

Durch eine Zweilagenmetallisierung, wie sie in der DE 36 37 513 A1 beschrieben ist, wird versucht, die Vielfalt der sich wiederholenden und untereinander zu isolierenden beiden Anschlüsse der Vorderseite der Leistungsbauelemente (z.B. MOSFET oder IGBT) auf ein lötbares oder druckkontaktierbares Maß zu reduzieren.

Dem Stand der Technik in der Leistungselektronik entspricht es üblicherweise noch immer, die benötigte Isolationsfestigkeit zwischen den spannungsführenden Teilen durch einen zusätzlich eingebrachten Schutz, wie beispielhaft Silikonkautschuk in Form eines Isolations- oder Weichvergusses herbeizuführen.

DE 31 19 239 A1 beschreibt demgegenüber einen Mehrschichtaufbau von Large-Scale-Integration- bzw. LSI- Halbleiterbauelementen. Hier ist bedingt durch sehr geringe Spannungen und Spannungsunterschiede zwischen den einzelnen internen Verschaltungen kein Erfordernis zur gegenseitigen Isolation der einzelnen Kontaktleitungen bzw. elektrischen Verbindungen untereinander gegeben.

Ein anderer Weg wird in der DE 44 07 810 A1 dargestellt, bei Leistungsaufbauten dieser Art wird der erforderliche Isolierverguß gleichzeitig in Doppelfunktion als Druckelement genutzt, so daß die Bauhöhe dieser Schaltungsanordnung immer noch ein bestimmtes Maß haben wird, auch wenn sie gegenüber den nach dem Stand der Technik hergestellten vergleichbaren Aufbauten reduziert ist. In der DE 41 32 947 A1 wird die stoffschlüssige Verbindung (Löten) durch eine stoffbündige Druckkontaktierung (Kleben oder Leitpastenfixierung) ersetzt, wobei einzelne Bauelemente ein-oder beidseitig mittels flexibler Leiterplatten kontaktiert werden. Zu dem Problem des Erzielens der erforderlichen Überschlagsfestigkeit bei hohen schaltungsinternen Spannungsunterschieden werden hier keine Aussagen getroffen.

Der vorliegenden Erfindung liegt die Aufgabe zugrunde, ein Halbleiterleistungsmodul der genannten Art vorzustellen, bei dem unter Vermeidung der Vergußtechnik über Druck- oder Lötkontakte alle elektrischen Verbindungen zwischen den Kontaktstellen beider Seiten der Halbleiterbauelemente schaltungsgerecht mit den äußeren Verbindungselementen hergestellt sind, wobei bei geringer Bauhöhe eine einwandfreie Isolation erzielt wird.

Die Aufgabe wird bei einem Halbleiterleistungsmodul durch die Maßnahmen des kennzeichnenden Teiles des Anspruches 1. gelöst, weitere vorteilhafte Ausbildungen sind in den Unteransprüchen genannt.

Bei der Realisierung von Halbleiterleistungsmodulen mit insbesondere hoher Leistungsdichte ist bei der Wahl der Methoden des Zusammenbaus auch die Isolationsfestigkeit zu gewährleisten. Die vorliegende Erfindung beschreibt einen Weg, wie die Erzielung der erforderlichen Isolation und die Langzeitlebensdauer der Schaltungsanordnung erreicht werden kann.

Die Erfindung wird im folgenden anhand der Figuren erläutert.
- **Fig. 1**: skizziert ein erfindungsgemäßes Halbleiterleistungsmodul im Querschnitt.
- **Fig. 2**: zeigt in flächiger Darstellung den Schichtaufbau gemäß Fig. 1.

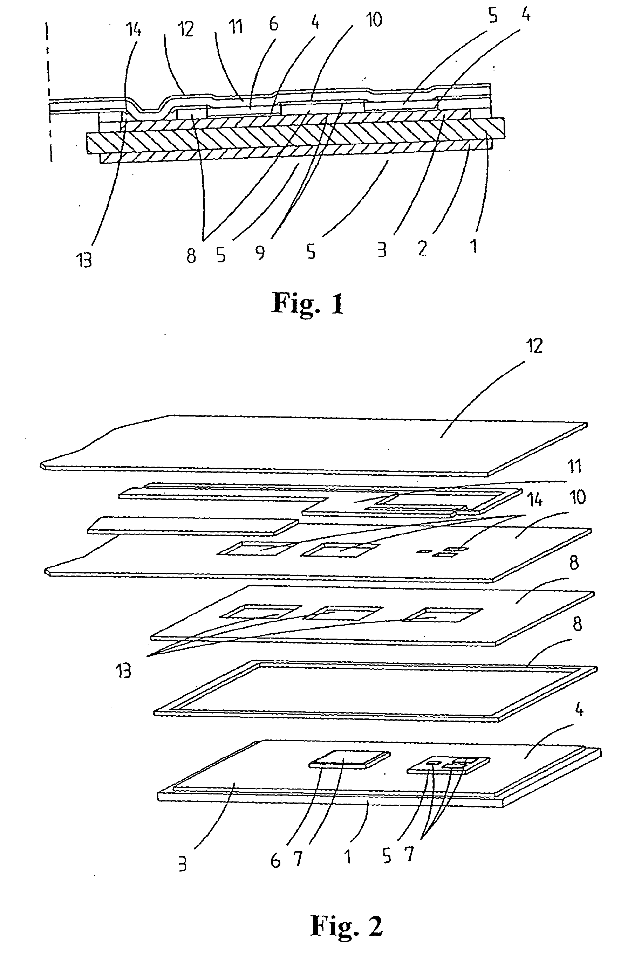

**Fig. 1** stellt in einer Skizze einen erfindungsgemäßen Modulausschnitt mit zwei kontaktierten Halbleiterbauelementen (5, 6) im Querschnitt dar. Grundlage für den Aufbau der Leistungsschalter ist z. B. eine DCB- Keramik, bestehend aus der Aluminiumoxidschicht (1), die beidseitig mit Kupfer (2, 3) beschichtet ist. Auf der in der Skizze oberen Kupferfläche (3) ist durch Löten mittels, nach dem Stand der Technik bekanntem Weichlot (4) ein ohmscher Kontakt zu der Rückseite der Halbleiterbauelemente, zum Kollektor des Transistors (5) bzw. zur beispielhaft dargestellten Freilaufdiode (6), hergestellt. Bei der Positionierung von weiteren Halbleiterbauelementen (5, 6) ist die Kupferfolie (3) entsprechend schaltungsgerecht strukturiert. Die in der Skizze oberen Kontaktflächen der Halbleiterbauelemente (5, 6) wurden in einem vorangehenden technologischen Bearbeitungsschritt mit einer lötfähigen, bei dem Leistungsschalter (5) strukturierten, Kontaktschicht versehen.

Der weitere Aufbau sieht den Einbau eines sog. Prepregs (8) vor, wie es beispielhaft von den Fa. Krempel, Postfach 484 in Stuttgart, und Isola, 52348 Düren, in deren Katalogen beschrieben wird. Dieses Prepreg (8) wird beispielhaft aus einem Glasgewebe/Epoxidharz- Laminat dadurch gebildet, daß es beidseitig mit einem Haftvermittler und einem Epoxidharz (9) beschichtet wurde, wobei das Epoxidharz (9) in dem Aushärtezustand B nach dem Stand der Technik vorbehandelt worden ist. Für die Halbleiterbauelemente (5, 6) und Kontaktstellen auf der Kupferschicht (2) des Substrates sind entsprechende Aussparungen (13) stanztechnisch in das Prepreg (8) eingearbeitet und die Kanten der Durchbrüche (13) sind mit Silikonkautschuk beschichtet. In der Dicke ist das Prepreg (8) konstruktiv so dimensioniert, daß es der Ebene der Oberfläche der Halbleiterbauelemente im gelöteten Zustand entspricht.

Auf die so gestaltete ebene Oberfläche, gebildet aus Halbleiterbauelementen (5, 6) und Prepreg (8) mit Epoxidharzbeschichtung (9) wird die vorbereitete flexible Leiterplatte laminiert, wobei das Laminieren zusammen mit der des Prepregs (8) auf die Kupferfläche (3) und die Keramik (1) gleichzeitig und zusammen mit dem Lötprozeß zur Kontaktierung der Halbleiterbauelemente (5, 6) erfolgen kann. Die flexible Leiterplatte besteht dabei aus den an sich bekannten Polyimidfolien (10, 12), wobei Folienstärken von 25 µm für die erforderlichen Durchschlagsfestigkeiten ausreichend sind. Diese umschließen die schaltungsgerecht strukturierten Kupferleitbahnen (11) und isolieren sie untereinander. In den Positionen (14) befinden sich in der unteren, zu den Halbleiterbauelementen (5, 6) gerichteten Polyimidfolie (10) der Leiterplatte Öffnungen, wodurch die Kupferleitbahnen (11), mit einer lötfähigen Oberfläche versehen, durch Löten entsprechend der Schaltungsstruktur, elektrisch kontaktiert worden sind. Die elektrische Verbindung zwischen der Kupferschicht (3) des Substrates (1, 2, 3) und den schaltungsgerechten Kupferleitbahnen (11) der flexiblen Leiterplatte wird in sehr einfacher Weise durch gleichzeitiges Löten realisiert, da der Vorteil der Flexibilität der Leiterplatte das ermöglicht.

Für die Realisierung des erfinderischen Gedankens sind die Kupferleitbahnen (11) der flexiblen Leiterplatte beachtlich. Bei hohen Leistungserfordernissen der Schaltungsanordnung kann eine Kupferstärke bis zu 0,4 mm gewählt werden. Durch den erfindungsgemäßen Schaltungsaufbau ist es möglich, die Breiten der Kupferleitbahnen (11) so zu gestalten, daß große Querschnitte für den Stromtransport zur Verfügung stehen, wodurch eine Erwärmung der Kupferleitbahnen (11) bei Arbeitsbelastung nicht durch den elektrischen Strom erfolgt, sondern diese Kupferleitbahnen (11) in gleichem Sinne, wie die Kupferflächen (3) des Substrates (1, 2, 3) für einen guten Wärmeabtransport von den Halbleiterbauelementen (5, 6) sorgen. Es ist in gleicher Weise die Weiterführung der Kupferleitbahnen (11) der Kraftanschlüsse in den Zwischenkreis, wie auch die Weiterleitung der Steueranschlüsse in den Elektronikteil der Schaltungsanordnung möglich.

Fig. 2 zeigt in räumlicher Darstellung den Schichtaufbau, wie er zu Fig. 1 bereits erläutert wurde. Das beidseitig mit flächigem Kupfer beschichtete Substrat (1) trägt auf der oberen Kupferfläche (3) die für die Schaltungsanordnung erforderlichen Halbleiterbauelemente (5, 6). Diese sind, wie bereits erläutert, positioniert aufgelötet oder für einen Druckkontaktaufbau mittels elektrisch leitender Zwischenschichten, wie Paste oder Kleber, fixiert. Das in seiner Größe angepaßte Prepreg (8) verfügt über die für die Aufnahme der Halbleiterbauelemente und für den direkte Kontaktierung der Kupferschicht (2) mit den entsprechenden Leiterzügen (11) der flexiblen Leiterplatte notwendigen Aussparungen (13).

Die für den Aufbau der flexiblen Leiterplatte gedachte untere Folie (10) verfügt über entsprechende Öffnungen (14) für den elektrischen Kontakt mit den Kontaktschichten (7) der beispielhaft gewählten Halbleiterbauelemente in den Positionen des Transistors (5) und der Freilaufdiode (6). Die für die elektrischen Verbindungen gedachten Kupferleitbahnen (11) sind in den Positionen des Kontaktes mit den Bauelementen, an den Stellen der Fenster (14) in der unteren Folie (10) oberflächenbehandelt. Die Deckfolie (12) sorgt für einen guten mechanischen und hervorragenden elektrischen Schutz gegenüber den sekundären Schaltungsaufbauten.

Die flexible Leiterplatte kann in gleicher Weise mehrschichtige Kupferlaminate, jeweils durch Polyimidfolien elektrisch voneinander isoliert, aufweisen, die untereinander schaltungsgerecht durch metallisierte Durchführungen verbunden werden können. Durch spiegelbildlich angeordnete gleichartige oder sich ergänzende Schaltungsaufbauten sind so erfindungsgemäß sehr hohe Packungsdichten realisierbar. Bei Verwendung von Wasserkühlsystemen ist der Wärmeabtransport von den Halbleiterbauelementen unproblematisch und es sind somit Schaltungsäufbauten mit großer Stoßfestigkeit insbesondere für den mobilen Einsatz herstellbar.

Der Aufbau nach Fig. 1 und 2 ist in ähnlicher Weise nach den Prinzipien des reinen Druckkontaktes nach dem Stand der Technik möglich, dazu ist der Einsatz eines entsprechend geformten Brückenelementes, eines Druckkissens und einer Druckplatte auf der Fläche der flexiblen Leiterplatte vorzusehen.

Dabei sind jedoch einige Besonderheiten beachtenswert. Die Halbleiterbauelemente (5, 6) müssen vor dem Laminieren des Prepregs (8) auf die Kupferfläche (3) elektrisch leitend so fixiert sein, daß kein Epoxidharz, durch Unterkriechen in der heißen Phase, den elektrischen Kontakt der Bauelementerückseite zur Kupferfläche (3) unterbricht. Durch die Vorvernetzung der Oberflächenepoxidharzschicht der Prepregs (8) und deren Strukturierung sowie durch den bereits erwähnten Kantenbelag der Durchbrüche (13) ist das Unterkriechen behindert.

Die Kontaktflächen (7) der Bauelemente (5, 6) müssen eine für Druckkontakte angepaßte Oberflächengüte besitzen, denn die sehr diffizilen Oberflächenschichten von beispielhaft MOSFET- und IGBT- Strukturen sind sehr empfindlich gegen ungleiche Druckbelastungen, das kann erreicht werden durch eine Belegung mit Silber in größerer Schichtdicke, beispielhaft > 10 µm, wie das auch für Lötverbindungen von Vorteil ist.

Die flexible Leiterplatte ihrerseits ist in einem Einsatz unter den Aufbaubedingungen des Druckkontaktes sehr gut geeignet, wenn punktuelle Drucküberbelastungen vermieden werden müssen. Dazu ist es zweckmäßig, Polyimidfolien in größeren Dicken, beispielhaft 50 µm oder 100 µm einzusetzen, diese wirken in dieser Dicke wie Druckausgleichspolster.

Der nach dem Stand der Technik übliche Weichverguß, beispielhaft siliziumorganische Verbindungen, kann bei erfinderischen Schaltungsaufbauten entfallen. Die Hermetisierung wird durch das Laminieren mit dem Prepreg vorgenommen. Die gegenseitige elektrische Isolation wird durch die Kantenbeschichtung der Durchbrüche (13) in den Prepregs (8) und die Polyimidfolien (10, 12) bewirkt. Daraus ist der erfinderische Vorteil eines sehr guten Wärmeüberganges auf beiden Seiten der Halbleiterbauelemente, unabhängig von der Variante des Aufbaus in Druckkontakt oder in Löttechnik, ableitbar. Die Vorteile des wesentlich geringeren Volumenbedarfes durch verringerte Bauhöhe und der größeren Flexibiltät in der Schaltungsausführung bedingt durch die Gestaltung der flexiblen Leiterplatte sind wirtschaftlich nennenswert.

## Patentansprüche

1. Halbleiterleistungsmodul hoher Packungsdichte in Mehrschichtaufbauweise mit mindestens einem elektrisch isolierenden Substrat (1), auf dem Flächen (3) aus elektrisch leitendem Material strukturiert sind, mit denen zu kühlende Halbleiterbauelemente (5, 6) elektrisch verbunden sind, die ihrerseits wiederum schaltungsgerecht mit äußeren Verbindungselementen (11) kontaktiert sind,
bei dem der Mehrschichtaufbau in Sandwichtechnik erfolgt ist und die Halbleiterbauelemente (5, 6) auf der einen Seite durch Löten oder mittels Druckkontakt elektrisch und thermisch mit den strukturierten Flächen (3) aus elektrisch leitendem Material des Substrates (1) verbunden sind, auf der anderen Kontaktseite (7) durch Löten oder mittels Druckkontakt alle schaltungsgerechten Verbindungen über eine flexible Leiterplatte (10, 11, 12) hergestellt sind
und die Isolation der Anordnung durch Einbau strukturierter Prepreg-Isolationszwischenlagen (8) zwischen dem Substrat (1) und der flexiblen Leiterplatte (10, 11, 12) erfolgt ist, wobei Aussparungen für die Halbleiterbauelemente und Kontaktstellen darin vorgesehen sind.

2. Halbleiterleistungsmodul nach Anspruch 1, **dadurch gekennzeichnet, daß**
die Halbleiterbauelemente (5, 6) Dioden, Bipolartransistoren, MOSFET oder IGBT sind und beidseitig für Druck- oder Lötkontaktierungen, einseitig strukturiert, beschichtet sind.

3. Halbleiterleistungsmodul nach Anspruch 1, **dadurch gekennzeichnet, daß**
die flexible Leiterplatte aus strukturierten Kupferleitbahnen (11) mit einer allseitigen Laminierung aus Polyimid (10, 12) besteht, deren Polyimidfolie (10) schaltungsgerechte Öffnungen für elektrische Kontaktstellen der Kupferleitbahnen (11) aufweist.

4. Halbleiterleistungsmodul nach Anspruch 1, **dadurch gekennzeichnet, daß**
die Isolation der Anordnung (8) aus einem Laminat, hergestellt aus einem Glasgewebe und Epoxidharz, besteht, das beidseitig über einen Haftvermittler mit einer Schicht Epoxidharz überzogen ist, die sich bei Einbau in die Sandwichstruktur in vorvernetztem Zustand, dem Aushärtezustand B, befindet.

5. Halbleiterleistungsmodul nach Anspruch 3, **dadurch gekennzeichnet, daß**
die Dicke des Polyimids (10, 12) entsprechend Schaltungserfordernis mindestens 25 µm beträgt, die einseitig mit einen Haftvermittler beschichtet worden ist.

6. Halbleiterleistungsmodul nach Anspruch 3, **dadurch gekennzeichnet, daß**
die flexible Leiterplatte entsprechend den Schaltungserfordernissen in den Kupferleitbahnen (11) so strukturiert ist, daß Ausgleichsbiegungen in der gleichen Ebene integriert sind und die Querschnitte der einzelnen Kupferleitbahnen den Stromaufnahmebedürfnissen der Schaltungsanordnung angepaßt sind.

7. Halbleiterleistungsmodul nach Anspruch 4, **dadurch gekennzeichnet, daß**
die Isolation der Anordnung (8) mindestens in zwei Lagen als Sandwich auf die Keramik (1) aufgebaut werden, wobei die Dicke der ersten Lage den Höhenausgleich bis zu der Oberfläche der Kupferstrukturschicht (3) und die Dicke der zweiten Lage den Höhenausgleich bis zu der Oberfläche der Halbleiterbauelemente (5, 6) bewirkt und jede Prepreglage eine der Struktur des Schaltungsaufbaus angepaßte geometrisch durch Stanzen angepaßte Form mit Durchbrüchen aufweist.

8. Verfahren zur Herstellung eines Halbleiterleistungsmoduls nach einem der vorhergehenden Ansprüche, **dadurch gekennzeichnet,**
**daß** der Mehrschichtaufbau durch Verpressen des Substrats (1, 2, 3) mit den Prepregs (8) und der flexiblen Leiterplatte (10, 11, 12) zeitlich gleich mit dem Löten aller Kontaktstellen der Halbleiterbauelemente (5, 6) auf die obere Kupferschicht (3) des Sußstrats (1) und an die Kontaktstellen (13, 14) der Kupferleitbahnen (11) der flexiblen Leiterplatte erfolgt.

## Claims

1. A semiconductor multilayer power module having high package density comprising at least one electrically insulating substrate (1) on which surfaces (3) of electrically conducting material are structured, to which semiconductor components (5, 6) to be cooled are electrically connected which for their part are in contact with external connection elements (11) appropriate to the circuit,
wherein the multilayer structure is made using sandwich technology and the semiconductor components (5, 6) are electrically and thermally connected to the structured surfaces (3) of electrically insulating material of the substrate (1) on one side by soldering or by means of pressure contacts and on the other contact side (7) all the connections appropriate to the circuit are made via a flexible printed circuit board (10, 11, 12) by soldering or by means of pressure contact
and the insulation of the arrangement is provided by insertion of structured prepreg-insulation layers (8) between the substrate (1) and the flexible printed circuit board (10, 11, 12), wherein recesses are provided therein for the semiconductor components and contact points.

2. The semiconductor power module according to claim 1, **characterised in that** the semiconductor components (5, 6) are diodes, bipolar transistors, MOSFET or IGBT and are coated on both sides for pressure or solder contacts and structured on one side.

3. The semiconductor power module according to claim 1, **characterised in that** the flexible printed circuit board consists of structured copper conductor paths (11) with polyimide lamination (10, 12) on all sides, whose polyimide film (10) has openings appropriate to the circuit for electrical contact points of the copper conductor paths (11).

4. The semiconductor power module according to claim 1, **characterised in that** the insulation of the arrangement (8) consists of a laminate made from a glass fabric and epoxy resin which is coated on both sides with a layer of epoxy resin by means of an adhesion promoter, which is located in the pre-cross-linked state, the curing state B, when inserted in the sandwich structure.

5. The semiconductor power module according to claim 3, **characterised in that** the thickness of the polyimide (10, 12) is at least 25 µm according to the circuit requirement, having been coated with an adhesion promoter on one side.

6. The semiconductor power module according to claim 3, **characterised in that** the flexible printed circuit board is structured according to the circuit requirements in the copper conductor paths (11) such that compensating bends are integrated in the same plane and the cross-sections of the individual copper conductor paths are matched to the power consumption needs of the circuit arrangement.

7. The semiconductor power module according to claim 4, **characterised in that** the insulation (8) is built up at least in two layers as a sandwich on the ceramic (1),
wherein the thickness of the first layer brings about height adjustment as far as the surface of the copper structural layer (3) and the thickness of the second layer brings about height adjustment as far as the surface of the semiconductor components (5, 6) and each prepeg layer has a shape with openings matched geometrically to the structure of the circuit structure.

8. A method for manufacturing a semiconductor power module according to any one of the preceding claims, **characterised in that** the multilayer structure is made by pressing the substrate (1, 2, 3) with the prepegs (87) and the flexible printed circuit board (10, 11, 12) at the same time as soldering all the contact points of the semiconductor components (5, 6) onto the upper copper layer (3) of the substrate (1) and onto the contact points (13, 14) of the copper conductor paths (11) of the flexible printed circuit board.

## Revendications

1. Module de puissance semi-conducteur à haute densité de composants en mode de construction multicouche, comportant au moins un substrat (1) électriquement isolant sur lequel sont structurées des surfaces (3) en matériau électriquement conducteur, avec lesquelles des composants semi-conducteurs (5, 6) à refroidir sont reliés électriquement, ces derniers étant de leur côté en contact approprié du point de vue commutation avec des éléments de liaison (11) extérieurs,
dans le cas duquel la structure multicouche a été effectuée en technique sandwich, et les composants semi-conducteurs (5, 6) sont reliés d'un côté électriquement et thermiquement, par brasage ou au moyen de contact par pression, aux surfaces structurées (3) en matériau électriquement conducteur du substrat (1), alors que de l'autre côté de contact (7), toutes les liaisons appropriées du point de vue commutation sont établies par brasage ou au moyen de contact par pression par l'intermédiaire d'une carte de circuits imprimés flexible (10, 11, 12), et
l'isolation du système étant effectuée par l'insertion entre le substrat (1) et la carte de circuits imprimés flexible (10, 11, 12) de couches intermédiaires d'isolation Prepreg (8) structurées, dans lesquelles sont prévus des évidements pour les composants semi-conducteurs et les points de contact.

2. Module de puissance semi-conducteur selon la revendication 1, **caractérisé en ce que**
les composants semi-conducteurs (5, 6) sont des diodes, des transistors bipolaires, des MOSFET ou des IGBT, et sont revêtus sur les deux faces pour des contacts par pression ou par brasage, et structurés sur une face.

3. Module de puissance semi-conducteur selon la revendication 1, **caractérisé en ce que**
la carte de circuits imprimés flexible est constituée de voies conductrices structurées en cuivre (11) avec une stratification en polyimide (10, 12) de tous côtés, dont le film en polyimide (10) comporte des ouvertures appropriées du point de vue commutation pour des points de contact électrique des voies conductrices en cuivre (11).

4. Module de puissance semi-conducteur selon la revendication 1, **caractérisé en ce que**
l'isolation du système (8) est constituée d'un stratifié fabriqué à partir d'un tissu de verre textile et de résine époxy, dont les deux faces sont revêtues par l'intermédiaire d'un agent d'adhérence d'une couche de résine époxy qui, lors du montage dans la structure sandwich, se trouve à l'état préalablement réticulé, l'état de durcissement B.

5. Module de puissance semi-conducteur selon la revendication 3, **caractérisé en ce que**,
de façon correspondante aux besoins de commutation, l'épaisseur du polyimide (10, 12) ayant été revêtu sur une face d'un agent d'adhérence est d'au moins 25 µm.

6. Module de puissance semi-conducteur selon la revendication 3, **caractérisé en ce que**,
de façon correspondante aux besoins de commutation, la carte de circuits imprimés flexible est structurée dans les voies conductrices en cuivre (11) de telle sorte que des inflexions de compensation soient intégrées dans le même plan, et que les sections transversales des différentes voies conductrices en cuivre soient adaptées aux besoins de consommation de courant du système de commutation.

7. Module de puissance semi-conducteur selon la revendication 4, **caractérisé en ce que**
l'isolation du système (8) est constituée d'au moins deux couches en tant que sandwich, sur lesquelles est appliquée de la céramique (1), l'épaisseur de la première couche assurant la compensation en hauteur jusqu'à la surface de la couche de structuration en cuivre (3), et l'épaisseur de la deuxième couche assurant la compensation en hauteur jusqu'à la surface des composants semi-conducteurs (5, 6), et chaque couche de Prepreg ayant une forme géométriquement adaptée par estampage à la structure du système de commutation, et comportant des percées.

8. Procédé destiné à la fabrication d'un module de puissance semi-conducteur selon l'une des revendications précédentes, **caractérisé en ce que**,
moyennant le pressage du substrat (1, 2, 3) avec les Prepregs (8) et la carte de circuits imprimés flexible (10, 11, 12), la structure multicouche est effectuée simultanément avec le brasage de tous les points de contact des composants semi-conducteurs (5, 6) sur la couche en cuivre supérieure (3) du substrat (1), et sur les points de contact (13, 14) des voies conductrices en cuivre (11) de la carte de circuits imprimés flexible.
